# EUROPEAN PATENT APPLICATION

(11) **EP 0 855 796 A2**
(43) Date of publication of application: **29.07.1998**
(21) Application number: 98101319.6
(22) Date of filing: 26.01.1998
(51) Int. Cl.: H03H 17/02

(54) **Matched filter and filter circuit**

(30) Priority: 27.01.1997 JP 25726/97; 14.03.1997 JP 79213/97
(71) Applicant: Yozan Inc., Tokyo 155 (JP)
(72) Inventor: Shou, Guoliang, Setagaya-ku, Tokyo 155 (JP); Motohashi, Kazunori, Setagaya-ku, Tokyo 155 (JP); Zhou, Changming, Setagaya-ku, Tokyo 155 (JP); Yamamoto, Makoto, Setagaya-ku, Tokyo 155 (JP); Zhou, Xuping, Setagaya-ku, Tokyo 155 (JP); Takatori, Sunao, Setagaya-ku, Tokyo 155 (JP); Qin, Xiaoling, Setagaya-ku, Tokyo 155 (JP)
(74) Representative: Grünecker, Kinkeldey, Stockmair & Schwanhäusser Anwaltssozietät

(57) **Abstract**

The invention provides according to a first aspect a low electric power consumption matched filter. The signal received at an input terminal is input to a shift-register having stages equal to the spread code length number after conversion into M-bit digital signals in an analog-to-digital converter. The outputs of the shift-register stages are input to EXCLUSIVE-OR circuits set corresponding to each stage, so that EXCLUSIVE-OR is performed between the outputs and corresponding spread code bits d₁ to d_{N}. The outputs of the EXCLUSIVE-OR circuits are analogously added in an analog adder and output from an output terminal. According to a second aspect the invention provides a filter circuit using an analog operation circuit to prevent lowering of operation accuracy caused by the residual charge. Input analog signals successively undergo sampling and holding in each sampling and holding circuit, are multiplied by coefficients stored in a shift register by multiplication circuits, and added in addition circuit. Sample data transmission error storage is prevented by shifting coefficients in the shift register. Sampling and holding circuits and multiplication circuits are formed by analog operation circuits, and each include a switch for canceling the residual charge. The sampling and holding circuits and multiplication circuits normally working are refreshed sequentially by providing circuits for replacing their function. The addition circuit is set double and refreshed in the same way.

## Description

The present invention relates to a matched filter for detecting the correlation between an input signal and a predetermined code sequence and to a filter circuit constituted by analog operation circuits.

A Direct Sequence (DS) Spread Spectrum (SS) communication system performs acquisition which estimates within 1-chip the timings of transmission signal spread code sequences and of spread code sequence generation prepared in a receiver, and makes a spread code generator in the receiver start to function by the timings.

There are two methods of performing this acquisition, by using (1) sliding correlators and (2) a matched filters.

Method (1) generates spread codes by roughly estimated timing and tries to receive them by gradual shifting. It multiplies a received signal and the spread code generated in the receiver to pass through a low-pass filter. Although the output of the low-pass filter obtains a large amplitude when phases of a received signal spread code and spread code being generated are identical, it obtains a low-level signal given by the auto-correlation function when the phases are not identical. Therefore, when the low-pass filter output is smaller than the predetermined level, the spread code phase generated by the spread code generator is slightly advanced or delayed. Repeating this identifies the phases of the transmission signal spread code and of the spread code generated in a receiver.

This method identifies phases by shifting the spread code generator phase by the time corresponding to one spread code cycle at most. When the spread code generator is working in a phase, it takes a single spread code cycle to ascertain if it is the adequate phase. It means that this method needs the time of (one spread code cycle)×(spread code length) at most until acquisition is completed.

Method (2) detects correlation values using matched filter, which soon completes acquisition. When SS modulated signals are continuously input from the receiving side of a matched filter, every moment's correlation value appears in succession at the output side of the filter. Therefore, the correlation value peak can be detected by watching the matched filter outputs during one spread code cycle. Using this method completes acquisition in the time corresponding to one spread code cycle.

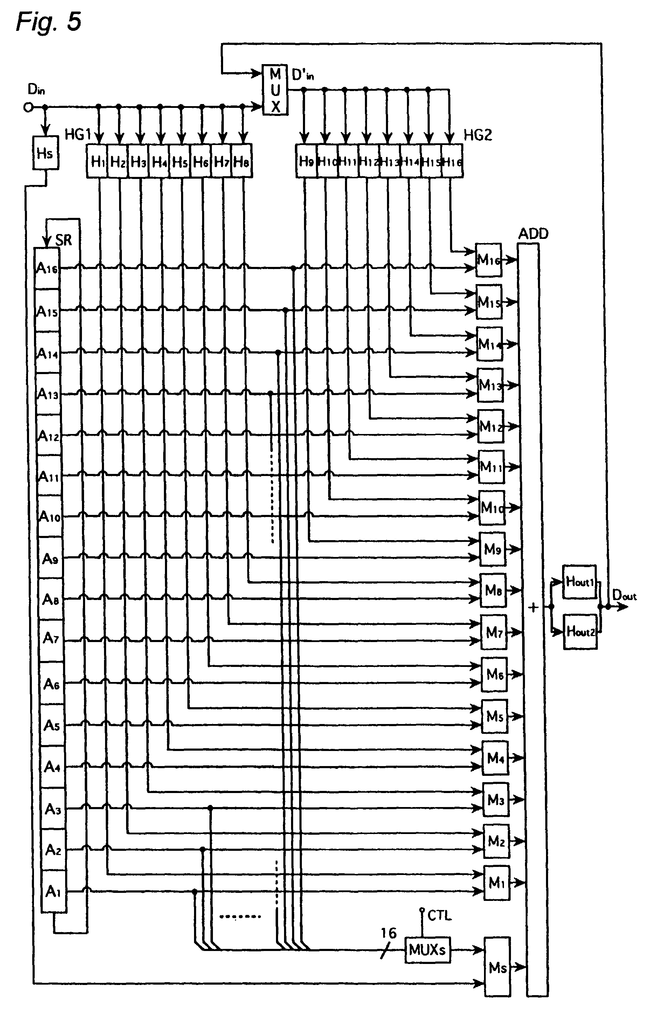

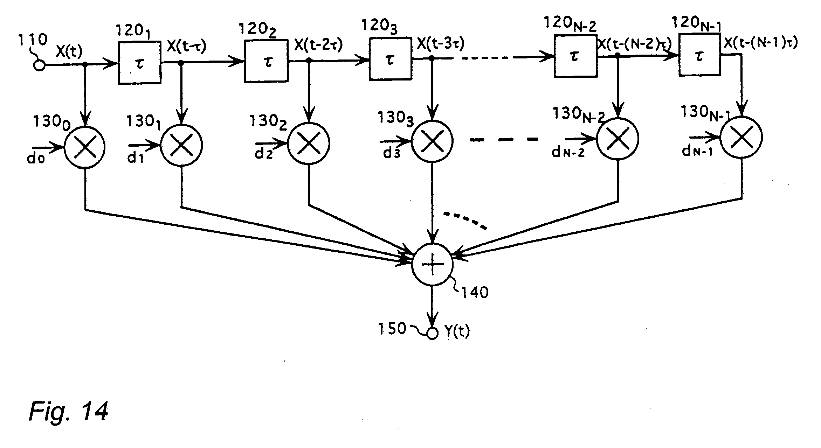

FIG. 14 shows a sample of conventional matched filter with a spread code length of N-bit. In FIG. 5, 110 is an input terminal, and 120₁ to 120_{N-1} are delay circuits for delaying input signals by unit time τ. Delay circuits 120₁ to 120_{N-1} are serially connected so that signals from 110 are sequentially delayed. Input signal X(t-iτ), which is iτ time before the present time, is output from 120ᵢ (i=1 to N-1) at the timing input terminal 110 receives signal X(t).

Numbers 130₀ to 130_{N-1} show multiplication circuits which multiply signals X(t-iτ) (i=0 to N-1) output from 110 or 120₁ to 120_{N-1} and bit di (i=0 to N-1) corresponding to the spread code produced by a spread code generator (not shown). Bit di is +1 or -1. The received signal is output as it is when the bit corresponding to the spread code is +1, and it is output with inverted polarity when the bit is -1.

Outputs from 130₀ to 130_{N-1} are added by adder 140 and output from output terminal 150. This terminal 150 outputs correlation output Y(t) shown in formula (1):$\text{Y} \text{(} \text{t} \text{)=} \text{i} \text{=0} \text{N} \text{-1} \text{di·X} \text{(} \text{t} \text{-} \text{i} \text{τ)}$ Observing Y(t) during a single spread code cycle yields the correlation peak between the input signals and the spread codes, and rapid acquisition is thus possible.

To form a matched filter like this, an analog delay line using a charged couple device (CCD) or a surface acoustic wave (SAW) device, and a digital circuit in which the shift register works as a delay circuit by converting received signals into digital data are used.

Acquisition using a sliding correlator requires little electric power consumption per unit time, but takes a long time to complete. There is heavy power consumption when acquisition is continuous.

Acquisition using a matched filter is completed in a short time. When an analog matched filter is used, electric power consumption is small but computation accuracy varies. When a digital one is used, the circuit size is large and electric power consumption is also large because many multiplications and additions have to be performed. With double sampling there is a larger sampling number and so a large circuit size, a serious problem affecting matched filter use in portable communication terminals.

Conventionally, a transversal filter is formed by discretely multiplying each sequential sampled data by a predetermined coefficient and adding the products. Since this type of filter usually transfers analog signals sampled and held in sequence, the process stores analog data holding errors. To minimize these errors, the present applicant proposes a filter circuit which stores each coefficient in a cyclic shift register and circulates them instead of transferring the sampled analog data, as in Japanese Patent Laid-Open Publication No. 6-164320.

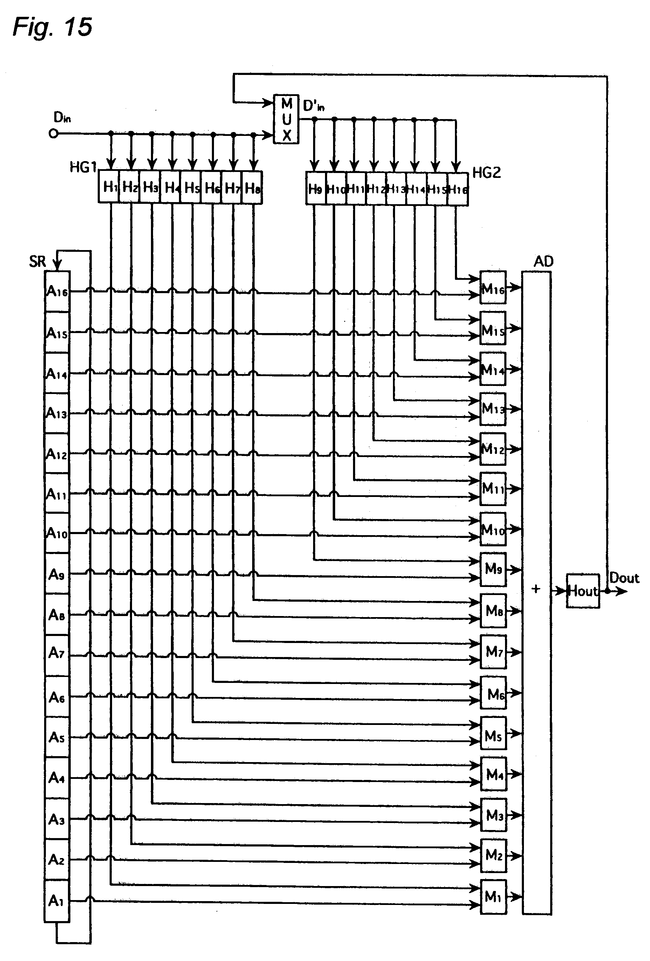

FIG. 15 shows a conventional filter circuit. In FIG. 15, HG1 is the first sampling and holding circuit group including eight sampling and holding circuits H₁ to H_{8,} which are connected to input terminal Din, and HG2 is the second sampling and holding circuit group including eight sampling and holding circuits H₉ to H_{16,} which are connected to output D'in of multiplexer MUX. This filter includes 16 sampling and holding circuits H₁ to H₁₆. H₁ to H₁₆ sample and hold analog signals receive input from Din or D'in according to the predetermined sampling signals, and store the sampled data until the next sampled signals are supplied.

MUX is provided between HG1 and HG2 to select Din or the output of holding circuit Hout (described later) as D'in.

SR is the 16-stage of cyclic shift register: each stage A₁ to A₁₆ stores the predetermined coefficients a₀ to a₁₅ that is to be multiplied by the discrete analog input signals which are sampled and held by H₁ to H₁₆ respectively. The memory is sequentially circulated by sampling signals (not shown) and shift-clock synchronized to the sampling signals.

M₁ to M₁₆ are multiplication circuits, whose first input terminal receives the discrete signal from H₁ to H_{16,} and whose other input terminal is connected to corresponding stage A₁ to A₁₆, respectively. This configuration multiplies the discrete analog signals output from H₁ to H₁₆ by digital data a₀ to a₁₅ from A₁ to A₁₆ in M₁ to M₁₆, respectively.

The multiplication results output from M₁ to M₁₆ are added in addition circuit AD, and their sum is output to holding circuit Hout. The output of Hout is also that of this filter circuit as well as another input of MUX.

The filter circuit having this structure works as below when MUX connects Din and HG2.

H₁ to H₁₆ are sequentially driven by every sampling cycle to sample and store analog input signals from Din. That is, at the first sampling timing, H₁ is driven and the input signal then is sampled and held in H₁. At the next sampling timing, H2 is driven and the input signal then is sampled and held in H₂. In this way, input signals are successively sampled and held in H₃ to H₁₆ at every sampling timing. After sampling data is held in H₁₆, input signals are successively sampled and held from H₁. Repeating this, all the necessary sequential data can be sampled and held by the predetermined timing without transferring data between sampling and holding circuits.

When analog signals from Din are successively sampled and 16 sequential data are held in H₁ to H₁₆ as above, coefficients a₀ to a₁₅ stored in SR and the sequential data in H₁ to H₁₆ are multiplied in M₁ to M₁₆, respectively, as described above. Then the multiplied results from M₁ to M₁₆ are added in AD and the sum is stored in Hout.

When new sequential data is sampled and held in H₁ in any subsequent sampling timing, the multiplication coefficients stored in SR are circularly shifted. This circularly-shifted multiplication coefficients and the sequential data stored in H₁ to H₁₆ are multiplied as described.

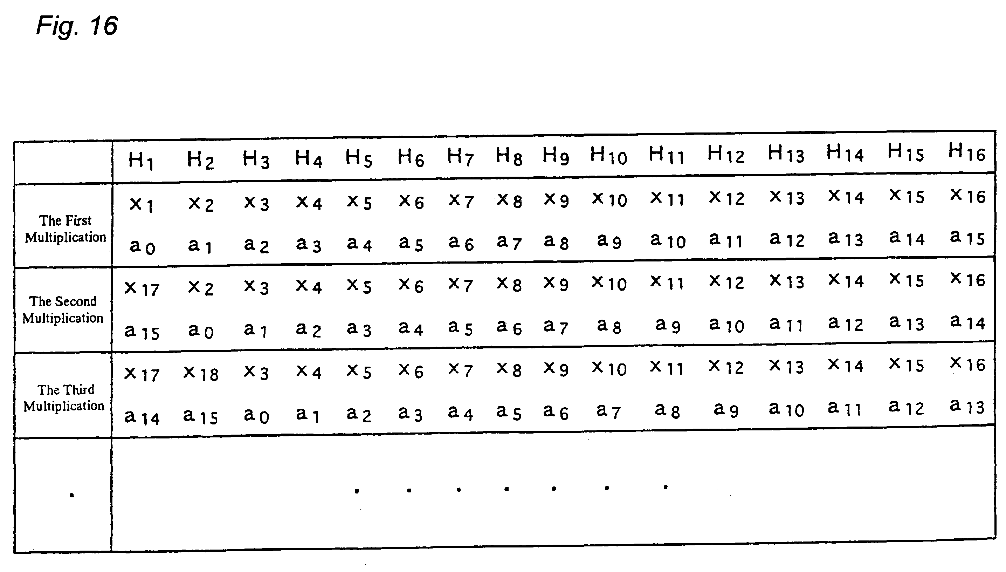

FIG. 16 shows the relationship between sequential data xᵢ stored in H₁ to H₁₆ and multiplication coefficients a₀ to a₁₅ stored in SR. As shown in FIG. 16, a₀ to a₁₅ are shifted to the next stage, and the coefficient at the last stage is returned to the first stage at every sampling of new sequential data. This makes it possible to execute an operation equivalent to shifting data xᵢ itself, which is held in the conventional structure, and to avoid holding errors caused by transferring sampled analog data.

When the multiplexer selects Din, this filter circuit functions as an FIR filter to executes the operation in formula (2);$\text{Y} \text{(} \text{t} \text{)=} \text{i} \text{=0} \text{15} {\text{a}}_{\text{15-} \text{i}} \text{X} \text{(} \text{t} \text{-} \text{i} \text{)}$ Here, Y(t) is the output, X(t) is the input, and aᵢ is the coefficient.

When the output of Hout is selected as D'in, this filter circuit functions as an IIR circuit to execute the operation in formula (3):$\text{Y} \text{(} \text{t} \text{)=} \text{i} \text{=0} \text{7} {\text{a}}_{\text{7-} \text{i}} \text{X} \text{(} \text{t} \text{-} \text{i} \text{)} \text{+} \text{i} \text{=0} \text{7} {\text{b}}_{\text{7-} \text{i}} \text{Y} \text{(} \text{t} \text{-1-} \text{i} \text{)}$ Y(t) is the output, X(t) is the input, aᵢ and bᵢ are the coefficients. In this case, SR is divided into two shift registers with eight stages to store aᵢ and b_{i.}

This filter circuit realizes FIR and IIR filters by switching MUX: when the FIR filter is actualized, many stages can be included utilizing all sampling and holding circuits and multiplication circuits. The circuit features low power consumption and high-speed operation, using an analog operation circuit (neural operation circuit which is described below) having sampling and holding circuits H₁ to H₁₆, multiplication circuits M₁ to M₁₆, and addition circuit AD.

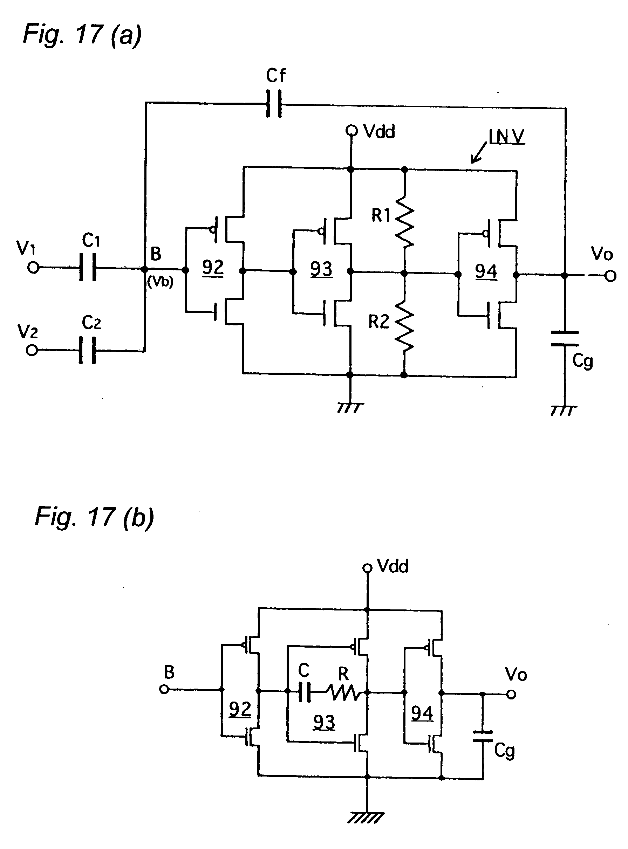

This neural operation circuit is described with reference to FIGS. 17 (a) and 17 (b). FIG. 17 (a) shows the fundamental structure of this neural operation circuit, where V1 and V2 are input terminals and INV is an inverting amplifier. INV utilize the characteristics of CMOS inverters its output transit from high-level to low-level or from low-level to high-level so as to use an inverter as an amplifier: it consists of an odd number of CMOS inverters in serial array, with three stages 92, 93 and 94 being shown, for example. Resistances R1 and R2 and capacitor Cg are set for controlling the amplifier gain and for adjusting phase, respectively, so as to prevent the oscillation of INV.

Input capacitors C₁ and C₂ are serially connected between V₁ and point B at the input of INV and between V₂ and point B, respectively. Feedback capacitor Cf is set and connected between output terminal Vo of INV and point B.

In a circuit with such a structure, the voltage-amplifying ratio of INV is very large, and the voltage at B is approximately constant and assumed to be Vb. Point B is connected to C₁, C₂, Cf and the gate of the transistor with structures 92, and B is also floating from every supply voltage.

When the electric charge stored in each capacitor at the initial state is 0, the total charge stored in each capacitor referencing B is 0, even after V₁ and V₂ are input. From this, formula (4) is true:${\text{C}}_{\text{1}} {\text{(V}}_{\text{1}} {\text{-Vb)+C}}_{\text{2}} {\text{(V}}_{\text{2}} \text{-Vb)+Cf(Vo-Vb)=0}$

Here, by replacing V₁ and V₂ and the reference voltage Vb at point B with ${\text{V(1)=V}}_{\text{1}} \text{-Vb}$, ${\text{V(2)=V}}_{\text{2}} \text{-Vb}$, and $\text{Vout=Vo-Vb}$, formula (5) is derived from formula (4):$\text{Vout} \text{= -} \left(\frac{{\text{C}}_{\text{1}}}{\text{Cf}} \text{V} \text{(1)+} \frac{{\text{C}}_{\text{2}}}{\text{Cf}} \text{V} \text{(2)}\right)$

The neural operation circuit outputs as the output voltage Vout the sum of V(i) multiplied by the coefficient Cᵢ/Cf, which is the ratio of input capacitor Cᵢ and feedback capacitor Cf, and which has inverted polarity. Formula (6) describes Vout:$\text{Vout} \text{= -} \left(\frac{{\text{C}}_{\text{1}}}{{\text{C}}_{\text{f}}} \text{V} \text{(1)+} \frac{{\text{C}}_{\text{2}}}{{\text{C}}_{\text{f}}} \text{V} \text{(2)+...+} \frac{{\text{C}}_{\text{i}}}{{\text{C}}_{\text{f}}} \text{V} \text{(} \text{i} \text{)+...+} \frac{\text{Cn}}{{\text{C}}_{\text{f}}} \text{V} \text{(} \text{n} \text{)}\right)$

The dynamic range is maximized by setting voltage Vb at B to be half of the supply voltage, $\text{Vb=Vdd/2}$, accordingly.

In FIG. 17 (a), controlling the gain of 93 using R1 and R2 prevents oscillation in INV. Other structures can also prevent it.

FIG. 17 (b) shows an alternative configuration having this function. In this configuration, INV connects a serial circuit including resistance R and capacitor C between the input and output of CMOS inverter 93 that is situated before the last stage. This serial circuit controls the gain of INV because it works as a negative feedback circuit of CMOS inverter 93 and works as its load. Therefore, this circuit forms a neural operation circuit consuming less electric power than that in FIG. 17 (a).

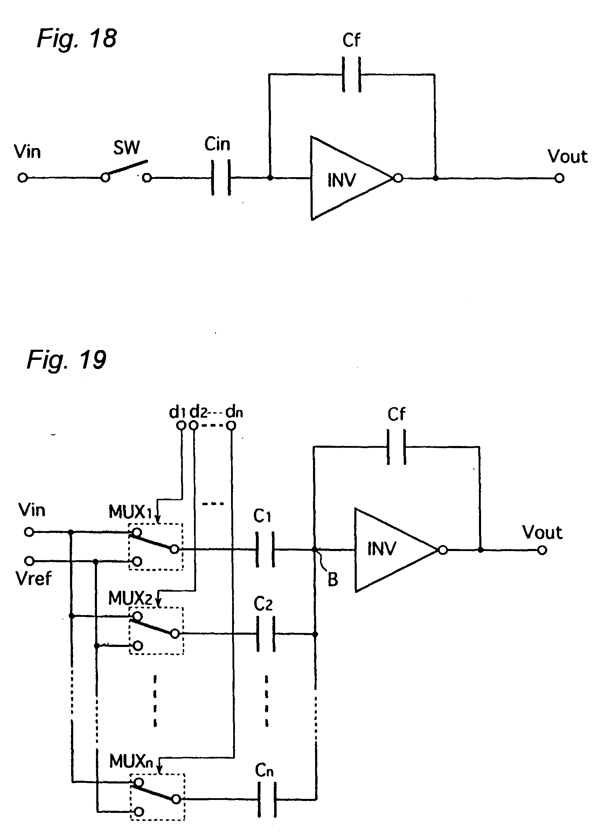

FIG. 18 shows an exemplary structure of a sampling and holding circuit using this neural operation circuit. In FIG. 18, Vin is the input voltage, SW is a sampling switching circuit, Cin is an input capacitor serially connected to the input of INV, Cf is the feedback capacitor in FIG. 17 (a), and Vout is the output voltage. Here, Cin and Cf have the same capacity, and SW includes a switching circuit using a MOS transistor like a CMOS transmission gate, for example.

As is clear from FIG. 18, this sampling and holding circuit is identical to the neural operation circuit in FIG. 17 (a) having only one input terminal. As Cin and Cf have the same values, the output voltage Vout is equal to -Vin from formula (5). By having SW closed first, and then opening it on the sampling timing the sampled inverted input voltage is output from the output terminal of this sampling and holding circuit as long as SW stays open: the voltage is held as it is until the sampling switch is closed.

FIG. 19 shows an exemplary multiplication circuit using this neural operation circuit. In FIG. 19, Vin is the input voltage, Vref is the reference potential, and $\text{Vref=Vdd/2=Vb}$. MUX₁ to MUXₙ are the multiplexers for switching the inputs to capacitors, whose first input terminals are connected to Vin and the second input terminals are connected to Vref, and whose output terminals are connected to input capacitors C₁ to Cₙ, respectively. MUX₁ to MUXn receive control signals d₁ to dₙ, respectively: when dᵢ (i=1 to n) is 1, input voltage Vin which is transmitted to the first input terminal is selected to be sent to corresponding input capacitor Cᵢ, and when dᵢ is 0, Vref (=Vb) is selected.

The other sides of C₁ to Cₙ are connected to point B at the input of INV, and feedback capacitor Cf is connected between the input and output of INV.

C₁ to Cₙ are set to satisfy formula (7), that is, the ratios of C₁ to Cₙ are the second power:${\text{C}}_{\text{n}} {\text{= 2C}}_{\text{n-1}} {\text{=}}^{\text{···}} {\text{= 2}}^{\text{i}} {\text{C}}_{\text{n-1}} {\text{=}}^{\text{···}} {\text{= 2}}^{\text{n-1}} {\text{C}}_{\text{1}}$ Electrical charge retention formula is shown in formula (8):$\text{i} \text{=1} \text{n} {\text{C}}_{\text{i}} {\text{d}}_{\text{i}} \text{(} \text{Vin} \text{-} \text{Vb} \text{)} \text{+} \text{i} \text{=1} \text{n} {\text{C}}_{\text{i}} \text{(1-} {\text{d}}_{\text{i}} \text{)(} \text{Vref} \text{-} \text{Vb} \text{)+} \text{Cf} \text{(} \text{Vout} \text{-} \text{Vb} \text{)=0}$ As $\text{Vref=Vb}$, Vout is expressed in formula (9):$\text{Vout =-} \frac{\text{1}}{\text{Cf}} \text{i} \text{=1} \text{n} {\text{C}}_{\text{i}} {\text{d}}_{\text{i}} \text{Vin} \text{=-} \frac{{\text{C}}_{\text{1}}}{\text{Cf}} \text{Vin} \text{i} \text{=1} \text{n} {\text{2}}^{\text{i}} {\text{}}^{\text{-1}} {\text{d}}_{\text{i}}$ That is, the multiplication results of Vin and n-bit binary numbers, each of whose bits corresponds to d₁ to d_{n,} are output as output voltage Vout.

Therefore, this circuit directly executes multiplication of the n-bit digital coefficient by the analog voltage, setting the coefficient data stored in stage A₁ of shift register SR in FIG. 15 as the control signal and the output from H1 as the input voltage Vin for transmitting.

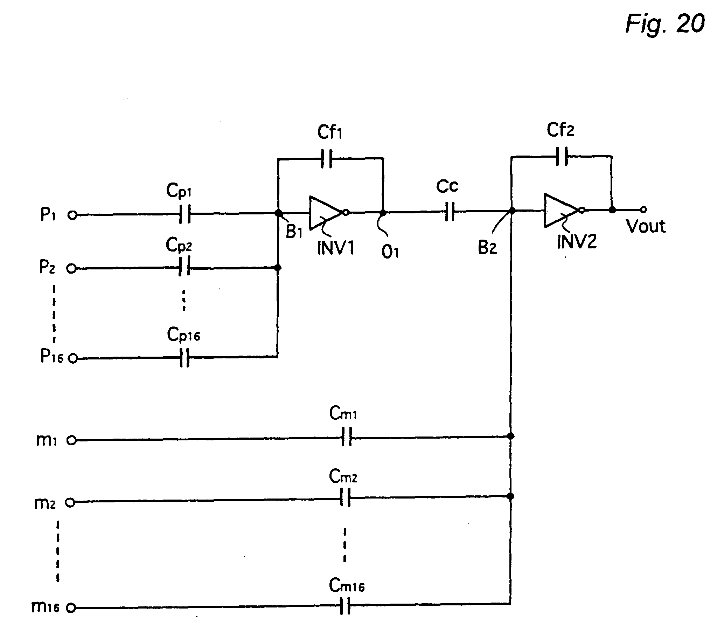

FIG. 20 shows an exemplary addition circuit using the neural operation circuit above. In FIG. 20, p₁ to p₁₆ and m₁ to m₁₆ are input terminals, Cₚ₁ to Cₚ₁₆ are input capacitors connected to p₁ to p₁₆, respectively, and Cₘ₁ to Cₘ₁₆ are input capacitors connected to m₁ to m_{16,} respectively. This is only one example: input terminals there can be any number.

In FIG. 20, INV1 is the first inverting amplifier, INV2 is the second inverting amplifier, B₁ and B₂ are the points at the inputs of INV1 and INV2, respectively, O₁ is the point at the output of INV1, Cf₁ and Cf₂ are the feedback capacitors of INV1 and INV2, respectively, and Cc is the capacitive coupling set between O₁ and B₂. Each of Cₚ₁ to Cₚ₁₆ and Cₘ₁ to Cₘ₁₆ is set equal to be Cin, and ${\text{Cc=Cf}}_{\text{1}} {\text{=Cf}}_{\text{2}}$.

In this configuration, when the input voltage magnitude input to p₁ to p₁₆ is assumed to be Vₚ₁ to Vₚ₁₆, respectively, output voltage V₀₁ is generated at O₁, formula (10) is derived from formula (6):${\text{}}_{\text{V}} {\text{}}_{\text{01}} \text{=-} \left(\frac{{\text{C}}_{\text{p}} {\text{}}_{\text{1}}}{{\text{Cf}}_{\text{1}}} {\text{V}}_{\text{p}} {\text{}}_{\text{1}} \text{+} \frac{{\text{C}}_{\text{p}} {\text{}}_{\text{2}}}{{\text{Cf}}_{\text{1}}} {\text{V}}_{\text{p}} {\text{}}_{\text{21}} \text{+...+} \frac{{\text{C}}_{\text{pi}}}{{\text{Cf}}_{\text{1}}} {\text{V}}_{\text{pi}} {\text{}}_{\text{1}} \text{+...+} \frac{{\text{C}}_{\text{pn}}}{{\text{Cf}}_{\text{1}}} {\text{V}}_{\text{n}} {\text{}}_{\text{1}}\right) \text{=-} \frac{{\text{C}}_{\text{p}} {\text{}}_{\text{1}}}{{\text{Cf}}_{\text{1}}} \text{(} {\text{V}}_{\text{p}} {\text{}}_{\text{1}} \text{+} {\text{V}}_{\text{p}} {\text{}}_{\text{2}} \text{+...+} {\text{V}}_{\text{pi}} {\text{}}_{\text{1}} \text{+...+} {\text{V}}_{\text{pn}} {\text{}}_{\text{1}} \text{)}$

When the input voltage transmitted to m₁ to m₁₆ is Vₘ₁ to Vₘ₁₆, output voltage Vout is obtained at the output terminal of INV2 as shown in formula (11):${\text{V}}_{\text{out}} \text{=-} \left(\frac{{\text{C}}_{\text{c}}}{{\text{Cf}}_{\text{2}}} {\text{V}}_{\text{01}} \text{+} \frac{{\text{C}}_{\text{mt}}}{{\text{Cf}}_{\text{2}}} {\text{V}}_{\text{m}} {\text{}}_{\text{1}} \text{+···+} \frac{{\text{C}}_{\text{m}} {\text{}}_{\text{2}}}{{\text{Cf}}_{\text{2}}} {\text{V}}_{\text{m}} {\text{}}_{\text{2}} \text{+···+} \frac{{\text{C}}_{\text{mn}}}{{\text{Cf}}_{\text{2}}} {\text{V}}_{\text{mn}}\right) \text{=-} {\text{V}}_{\text{01}} \text{-} \left(\frac{{\text{C}}_{\text{m}} {\text{}}_{\text{1}}}{{\text{Cf}}_{\text{2}}} {\text{V}}_{\text{m}} {\text{}}_{\text{1}} \text{+} \frac{{\text{C}}_{\text{m}} {\text{}}_{\text{2}}}{{\text{Cf}}_{\text{2}}} {\text{V}}_{\text{m}} {\text{}}_{\text{2}} \text{+...+} \frac{{\text{C}}_{\text{mn}}}{{\text{Cf}}_{\text{2}}} {\text{V}}_{\text{mn}}\right) \text{=-} \frac{{\text{C}}_{\text{p}} {\text{}}_{\text{1}}}{{\text{Cf}}_{\text{2}}} \text{(} {\text{V}}_{\text{p}} {\text{}}_{\text{1}} \text{+} {\text{V}}_{\text{p}} {\text{}}_{\text{2}} \text{+···+} {\text{V}}_{\text{pn}} \text{-} {\text{V}}_{\text{m}} {\text{}}_{\text{1}} \text{-} {\text{V}}_{\text{m}} {\text{}}_{\text{2}} \text{-···-} {\text{V}}_{\text{mn}} \text{)}$ That is, output voltage Vout of this addition circuit is (Cₚ₁/Cf₂) times as large as the voltage obtained by adding Vₚ₁ to Vₚ₁₆ from p₁ to p₁₆ and subtracting Vₘ₁ to Vₘ₁₆ from m₁ to m₁₆.

In the filter circuit in FIG. 15, the necessary addition results can be obtained by respectively transmitting the output of Mᵢ and the reference potential Vref (=Vb) to input terminals pᵢ and mᵢ when coefficient aⱼ of SR corresponding to the output of i-th sampling and holding circuit Hᵢ is positive, and by respectively transmitting Vref and the output of Mᵢ to pᵢ and mᵢ when aⱼ is negative.

Using a neural operation circuit like that above forms a high-speed, low power consumption filter circuit. However, any analog operation circuit like this present neural one generates a residual charge in its inverter or a capacitor while operating: the offset voltage so generated decreases the output accuracy

According to a first aspect of the invention the purpose is to provide a matched filter having both analog and digital merits, small circuit-size, and low electric power consumption.

To achieve the above object, the matched filter of this invention includes an analog-to-digital converter for sampling and converting an input signal into predetermined digital data, a shift-register having a predetermined number of stages for receiving the output of the analog-to-digital converter, an EXCLUSIVE-OR circuit corresponding to each stage of the shift-register, for performing EXCLUSIVE-OR operations between the predetermined bits of digital data output from the stage corresponding to the shift-register and its corresponding bit of spread code; and an adder for adding the outputs of each EXCLUSIVE-OR circuit.

The analog adder is configured by analog addition circuits with the number corresponding to the bit numbers of the digital data for receiving bits with weights corresponding to the output of those from each EXCLUSIVE-OR circuit, and analog adders for giving corresponding weights to add to the outputs from each analog adder.

The analog-to-digital converter includes a predetermined number of threshold circuits comprising a capacitive coupling and an inverting amplifier, and an encoder for receiving the outputs of the predetermined number of threshold circuits.

Since the present matched filter employs a shift-register as a delay circuit, it does not store errors during delay processing, and electric power consumption is low. Also, since EXCLUSIVE-OR circuits perform multiplications in this matched filter, a multiplication circuit can be formed very easily. Moreover, as this matched filter uses analog adders for analogously adding input digital signals, it performs operations with low electric consumption, at high speed, and with high accuracy.

The present invention has according to a second aspect as a further object to prevent decreased output accuracy caused by the residual charge in a filter circuit using an analog operation circuit.

To achieve this object, a filter circuit according to the present invention includes a plurality of sampling and holding circuits for successively performing sampling and holding on input analog signals, a cyclic shift register for storing coefficient data in each stage, a plurality of analog multiplication circuits for multiplying the output signals from the plurality of sampling and holding circuits and coefficient data from the cyclic shift register, and an analog addition circuit for calculating the multiplication circuits' outputs sum, wherein the plurality of sampling and holding circuit, multiplication circuits and addition circuits comprises a refreshing means for canceling offset voltage caused by the residual charge.

In this filter circuit, an auxiliary sampling and holding circuit, an auxiliary multiplication circuit and an auxiliary addition circuit are provided and replace the sampling and holding circuits, the multiplication circuits and the addition circuits, respectively, during refreshing.

The auxiliary sampling and holding circuit and the auxiliary multiplication circuit are commonly provided to the plurality of sampling and holding circuits and the plurality of multiplication circuits, respectively.

The auxiliary sampling and holding circuit, auxiliary multiplication circuit and auxiliary addition circuit constitute refreshing means for canceling offset voltage caused by the residual charge.

The sampling and holding circuit, the multiplication circuits, the addition circuits, the auxiliary sampling and holding circuit, the auxiliary multiplication circuit and auxiliary addition circuit each include an inverting amplifier consisting of an odd number of stages of serially-connected CMOS inverters, an input capacitor connected to the input of the inverting amplifier, and a feedback capacitor connected between the input and output of the inverting amplifier. The refreshing means includes a switching means for short-circuiting the feedback capacitor and a means for supplying the reference voltage to the input of the input capacitor.

Also, the sampling and holding circuits, the multiplication circuits, the addition circuits, the auxiliary sampling and holding circuit, the auxiliary multiplication circuit and auxiliary addition circuit each include an inverting amplifier consisting of an odd number of stages serially-connected CMOS inverters, an input capacitor connected to the input of the inverting amplifier, and a feedback capacitor connected between the input and output of the inverting amplifier. The refreshing means includes a switching means for short-circuiting the feedback capacitor and a means for supplying the reference voltage to the input of the input capacitor and the output of the feedback capacitor.

The refreshing means maintains output accuracy against the offset voltage of the residual charge. Since the common auxiliary sampling and holding circuit and multiplication circuit are respectively set for the plurality of sampling and holding circuits and multiplication circuits, the latter are sequentially refreshed without impeding normal work, and necessary hardware is minimally increased.

This invention will be described in detail in conjunction with the accompanying drawings:
FIG. 1 shows a block diagram of the embodiment structure of the matched filter according to the present invention.
FIG. 2 shows a block diagram of the analog adder structure of the matched filter according to the present invention.
FIG. 3 shows the operation circuit configuration of the analog adder in FIG. 2.
FIG. 4 shows an exemplary configuration of an analog-to-digital converter in the matched filter in the present invention.
FIG. 5 shows a block diagram of the overall filter circuit according to the present invention.
FIG. 6 shows an exemplary sampling and holding circuit.
FIG. 7 shows another exemplary sampling and holding circuit.
FIG. 8 shows an exemplary sampling and holding circuit other than those in FIGS. 6 and 7.
FIG. 9 shows an exemplary multiplication circuit.
FIG. 10 shows an adder.
FIG. 11 shows an exemplary addition circuit.
FIG. 12 shows another exemplary addition circuit.
FIG. 13 shows a timing chart of the function of the present filter circuit.
FIG. 14 serves to explain the matched filter structure.
FIG. 15 shows a block diagram of a conventional filter circuit.
FIG. 16 shows actions of the filter circuit in FIG. 15.
FIGS. 17 (a) and 17 (b) show a neural operation circuit.
FIG. 18 shows a sampling and holding circuit of a conventional filter circuit.
FIG. 19 shows a multiplication circuit of the conventional filter circuit.
FIG. 20 shows an addition circuit of the conventional filter circuit.

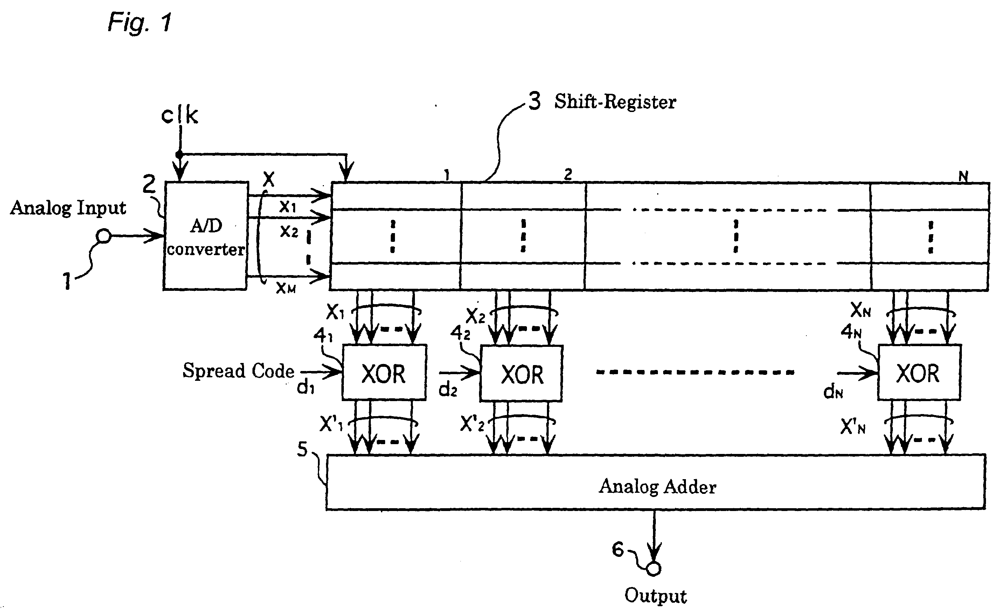

FIG. 1 shows a block diagram of a matched filter embodiment according to a first aspect of the present invention. In FIG. 1, 1 is an input terminal to receive analog signals, 2 is an analog-to-digital converter for converting analog signals input to digital data of 1 to M-bit after sampling according to sampling clock clk, and 3 is an N-stages shift-register for storing M-bit digital data from 2 in each stage at every sampling timing. Numbers 4₁ to 4_{N} are EXCLUSIVE-OR circuits (XOR-circuits) set to correspond to each stage of 3, perform XOR-operations between the M-bit digital data and the corresponding bit of the spread code generated by a spread code generator (not shown), and 5 is an analog adder for adding the outputs of 4₁ to 4_{N}.

The present matched filter samples a signal input from 1 by every clk in 2, and converts it into M-bit digital data X (x₁, x₂, ..., x_{M}). Hereinafter, X shows a sampled digital data, and x₁, x₂, ..., x_{M} show each bits of the digital data. Analog-to-digital converter 2 outputs M-bit digital data X obtained by quantizing received signals from negative maximal value to positive maximal value in 2^{M} stages.

The bit number M of X can be any number according to the usage, but usually it is from 1 to 4 bits. A small bit number makes the circuit size small: for example, to perform acquisition of DS-CDMA, necessary accuracy can be obtained even when M=1.

X output from 2 is input to 3, clk is input to 3 as a shift clock, and X is shifted to the following stages in sequence according to clk. The stage number N of 3 is equal to one cycle of spread code. The output of each stage is expressed by Xi (i=1 to N), each of which is configured by each bit of xᵢ₁, xᵢ₂, ..., x_{iM}.

The output of each stage of 3, X₁ to X_{N} is then sent to a corresponding input of 4, 4₁ to 4_{N}. Corresponding spread code bits di (i=1 to N), or their inverted bits, are each sent to another input of 4₁ to 4_{N}. In 4i, XOR is executed between M-bit digital data Xi output from each stage of 3 and di corresponding to the spread code. Here, di is 1 or 0: Xi is output as it is when di=0, and each bit (x₁, x₂, ..., x_{M}) of Xi is inverted to output when di=1. In short, output X'i of 4i is the inverted value of input Xi when di=1, and Xi is output as it is when di=0. In this way, di and Xi are multiplied in 4₁ to 4_{N}.

The multiplied result data X'i (i=1 to N) from 4₁ to 4_{N} are input to analog adder 5 to be analogously added; consequently, correlation output voltage Y(t) is obtained at output terminal 6 as shown in formula (1).

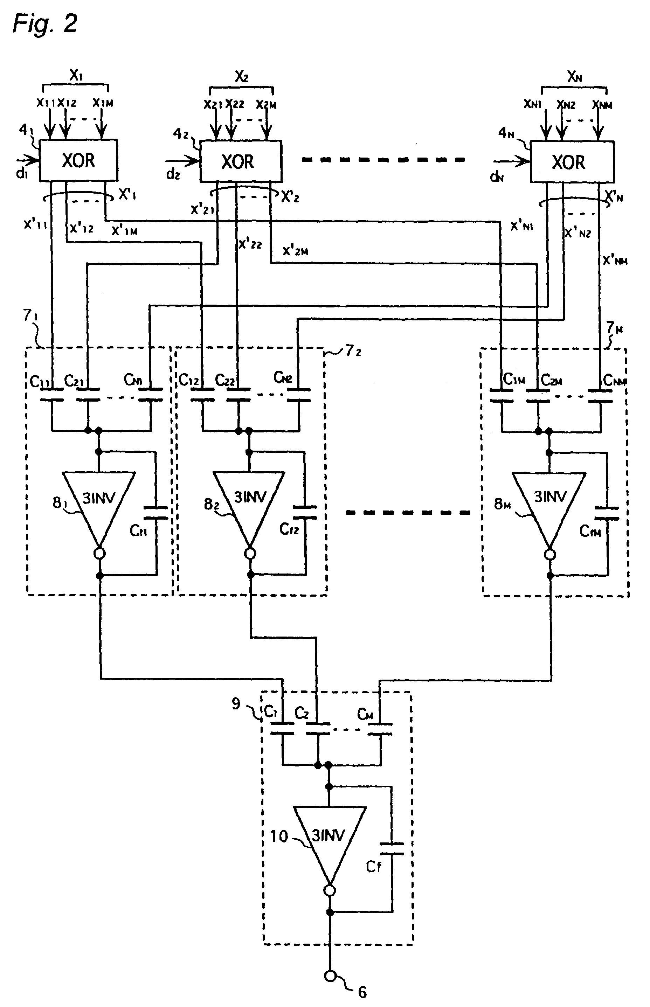

FIG. 2 shows an exemplary embodiment of 5, where 4₁ to 4_{N} are XOR-circuits which receive signals X₁ to X_{N} from corresponding stages of the shift register 3, respectively. X₁ to Xₙ are M-bit data, as already described, and data Xᵢ has bits from xᵢ₁ to x_{iM}. xᵢ₁ is the first bit (the lowest bit), x_{iM} is the M-th bit (the uppermost bit), and the bit weight of each bit is 2⁰, 2¹, ...2^{M-1}.

To recapitulate, XOR-operations between Xi and corresponding bit dᵢ to d_{N} are performed in 4₁ to 4_{N,} from which corresponding output X'1 to X'N are output. X'i is the M-bit data of x'ᵢ₁, x'ᵢ₂, ...x'_{iM}.

Each bit x'ᵢ₁ to x'_{iM} of signal X'ᵢ is input to adders 7₁ to 7_{M} set corresponding to each bit weight. That is, with respect to outputs X'₁ to X'_{N} of 4₁ to 4_{N}, each first bit x'₁₁, x'₂₁, ...x'_{N1} is input to adder 7₁, each second bit x'₁₂, x'₂₂, ...x'_{N2} is input to adder 7₂, and in the same way, every bit is input to the adder 7ⱼ (j=1 to M) corresponding to the bit location.

Each adder 7ⱼ (j=1 to M) includes N number of input capacitances C₁ⱼ to C_{Nj}. The outputs of each bit from 4₁ to 4_{N} are connected to the corresponding input capacitance Cᵢⱼ in the corresponding adder.

As shown, inverting amplifiers 8₁ to 8_{M} indicated by 3INV are set in 7₁ to 7_{M}. C₁ⱼ to C_{Nj} are connected to the input of the corresponding inverting amplifier 8ⱼ. The output of 8ⱼ is also the output of 7ⱼ, and feedback capacitance C_{fj} is connected between each input and output of inverting amplifier 8ⱼ.

The outputs of 7₁ to 7_{M} are input to respective input capacitances C₁ to C_{M} of adder 9. In the same way as in 7₁ to 7_{M}, input capacitances C₁ to C_{M} in 9 are connected to the input of inverting amplifier 10, and feedback capacitance Cf is connected between the input and output of 10. The output of 10 is connected to output terminal 6.

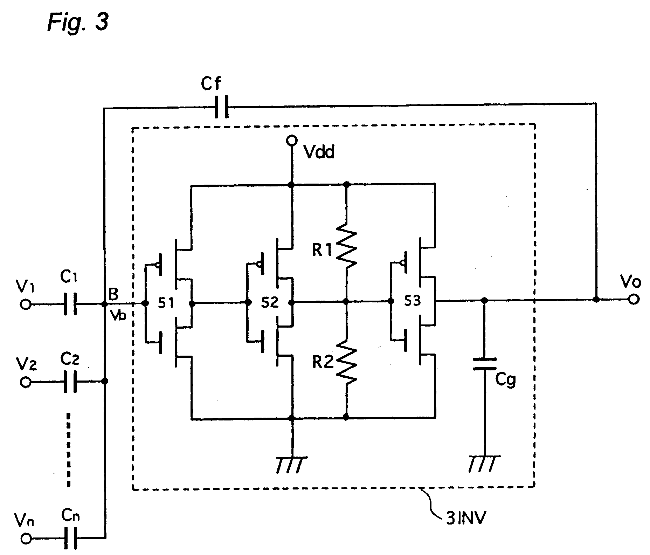

As expressed, 7₁ to 7_{M} and 9 have the same structures and functions which are described in detail with reference to FIG. 3.

In FIG. 3, V₁, V₂, ... Vₙ are input terminals, Vo is an output terminal, and 3INV is the inverting amplifier. This inverting amplifier 3INV utilizes the characteristics of CMOS inverters which perform output transits from high-level to low-level or from low-level to high-level so as to use an inverter as an amplifier. It includes an odd number of serially connected CMOS inverters, with CMOS inverters 51, 52 and 53 being shown in FIG. 3.

C1 to Cn are input capacitances provided between respective input terminals V₁ to Vₙ and point B of the input of 3INV, and Cf is a feedback capacitance connected between Vo and point B. Resistances R1 and R2 are set so as to control the amplifier gain, and capacitance Cg is set to adjust the phase, not to prevent the oscillation of 3INV.

In this adder, the voltage Vb at point B is approximately constant because the voltage amplifying ratio of 3INV is very large. Here, point B is connected to capacitances C1 to Cn, to Cf and to the transistor gate forming CMOS inverter 51, and is floating from all the voltage supply.

At the initial state, assuming the electric charge stored in each capacitance is 0, and when the reference level is set at B, the total electric charge stored in each capacitance is 0, even when V₁ to Vₙ are input. From this, electrical charge retention formula (12) is true:${\text{C}}_{\text{1}} {\text{(V}}_{\text{1}} {\text{-Vb)+C}}_{\text{2}} {\text{(V}}_{\text{2}} {\text{-Vb)+...+C}}_{\text{n}} {\text{(V}}_{\text{n}} \text{-Vb)+Cf(Vo-Vb)=0}$ Since the dynamic range is maximum by setting Vb as half of the supply voltage which is transmitted to 3INV, $\text{Vb=Vdd/2}$, when the supply voltages are provided by +Vdd and the grounded potential usually, and Vb=0 when the supply voltages are both positive and negative. Here, assuming that the supply voltages are +Vdd and the grounded potential, and $\text{Vb=Vdd/2}$, formula (13) is derived from formula (12):$\text{Vo} \text{= -} \left(\frac{{\text{C}}_{\text{1}}}{\text{Cf}} {\text{V}}_{\text{1}} \text{+} \frac{{\text{C}}_{\text{2}}}{\text{Cf}} {\text{V}}_{\text{2}} \text{+...+} \frac{{\text{C}}_{\text{n}}}{\text{Cf}} {\text{V}}_{\text{n}}\right) \text{+} \frac{{\text{C}}_{\text{1}} \text{+} {\text{C}}_{\text{2}} \text{+...+} {\text{C}}_{\text{n}} \text{+} \text{Cf}}{\text{2} \text{Cf}} \text{Vdd}$ Inverting amplifier 3INV outputs voltage Vo having offset voltage (${\text{(C}}_{\text{1}} {\text{+C}}_{\text{2}} {\text{+...+C}}_{\text{n}} \text{+Cf)Vdd/(2Cf)}$) and added to this the value of the sum of each input voltage V₁, V₂,...Vₙ multiplied by a coefficient which is the ratio of C₁, C₂, ...Cₙ and feedback capacitance Cf (C₁/Cf, C₂/Cf,...Cₙ/Cf) and having inverted polarity.

It is provided that input capacitances C1, C2,...Cn are equal as in formula (14), and Cf is the sum of all input capacitances as in formula (15):$\begin{matrix}\begin{matrix}\begin{matrix}{\text{C}}_{\text{1}} {\text{=C}}_{\text{2}} {\text{=C}}_{\text{3}} {\text{=...C}}_{\text{N}}\end{matrix} \\ \begin{matrix}{\text{Cf=NC}}_{\text{1}}\end{matrix}\end{matrix}\end{matrix}$ In this case, formula (16) is derived from formula (13), that is, Vo is calculated by dividing the sum of V₁ to V_{N} by the input number, inverting its polarity, and adding the offset of Vdd to it:$\text{Vo} \text{= -} \frac{\text{1}}{\text{N}} \text{(} {\text{V}}_{\text{1}} \text{+} {\text{V}}_{\text{2}} \text{+...+} {\text{V}}_{\text{N}} \text{)+} \text{Vdd}$

Assuming that the grounded potential and the predetermined voltage are output as 0-output and 1-output, respectively, from each of 4₁ to 4_{N}, and that input capacitances C₁₁ to C_{N1}, C₁₂ to C_{N2},...C_{1M} to C_{NM} are equal in adders 7₁ to 7_{M}, respectively, and assuming further that each feedback capacitance C_{f1} to C_{fM} is the sum of its corresponding input capacitances, then the analog output voltage corresponding to the number of input bit 1 is output respectively from output terminals of 7₁ to 7_{M}, as is clear from formula (16).

That is, the analog voltage corresponding to the number of the lowest bits (X'₁₁, X'₂₁,...X'_{N1}) the value of which is 1 among the outputs of XOR-circuits 4₁ to 4_{N} is generated from the output of adder 7₁ (inverting amplifier 8₁), and the analog voltage corresponding to the number of 2¹ bits (X'₁₂, X'₂₂,...X'_{N2}) the value of which is 1 in the outputs from 4₁ to 4_{N} is generated from the output of adder 7_{2;} similarly, in the following stage, the analog voltage corresponding to the number of bit of corresponding weight whose value is 1 the weight is output. Generally, the analog voltage corresponding to the number of 2^{M-1} bits (X'_{iM}, X'_{2M},... X'_{NM}) whose value is 1 in the output of 4₁ to 4_{N} is output from adder 7_{M}.

Providing that input capacitances C₁ to C_{M} in adder 9 have the relationship given in formula (17), and that feedback capacitance Cf is equal to the sum of C₁ to C_{M} as in formula (18), formula (13) is transformed into formula (19):$\begin{matrix}\begin{matrix}\begin{matrix}{\text{C}}_{\text{M}} {\text{=2C}}_{\text{M-1}} {\text{=2}}^{\text{2}} {\text{C}}_{\text{M-2}} {\text{=...2}}^{\text{M-2}} {\text{C}}_{\text{2}} {\text{=2}}^{\text{M-1}} {\text{C}}_{\text{1}}\end{matrix} \\ \begin{matrix}\text{Cf} \text{=} \text{i} \text{=1} \text{M} {\text{C}}_{\text{i}}\end{matrix} \\ \begin{matrix}\text{Vo} \text{= -} \frac{{\text{C}}_{\text{1}}}{\text{Cf}} \text{(} {\text{V}}_{\text{1}} \text{+2} {\text{V}}_{\text{2}} {\text{+2}}^{\text{2}} {\text{V}}_{\text{3}} {\text{+}}^{\text{...}} {\text{+2}}^{\text{M}} {\text{}}^{\text{-1}} {\text{V}}_{\text{M}} \text{)+} \text{Vdd}\end{matrix}\end{matrix}\end{matrix}$ The voltage summed after multiplying the corresponding weight to the sum of each bit generated in 7₁ to 7_{M} is obtained from output terminal 6 of amplifier 9.

The analog addition circuit configuration is not limited to the embodiment above. If the digital data output from the XOR-circuits can be added analogously, any circuit is adaptable. For example, converting the outputs of the XOR-circuits into analog signals permits them being added by analog addition circuit.

As mentioned, the present matched filter uses the shift-register as a delay circuit because the input signal is digitized: this means that a delay circuit can be easily formed. Since multiplication is executed by the XOR-circuits, the multiplication circuit can be simplified. The output voltage from each XOR-circuit can be added in analog adder 5 with low electric power consumption and high accuracy. Especially when the output bit number M from A/D converter 2 decreases, a very small-size circuit can be realized.

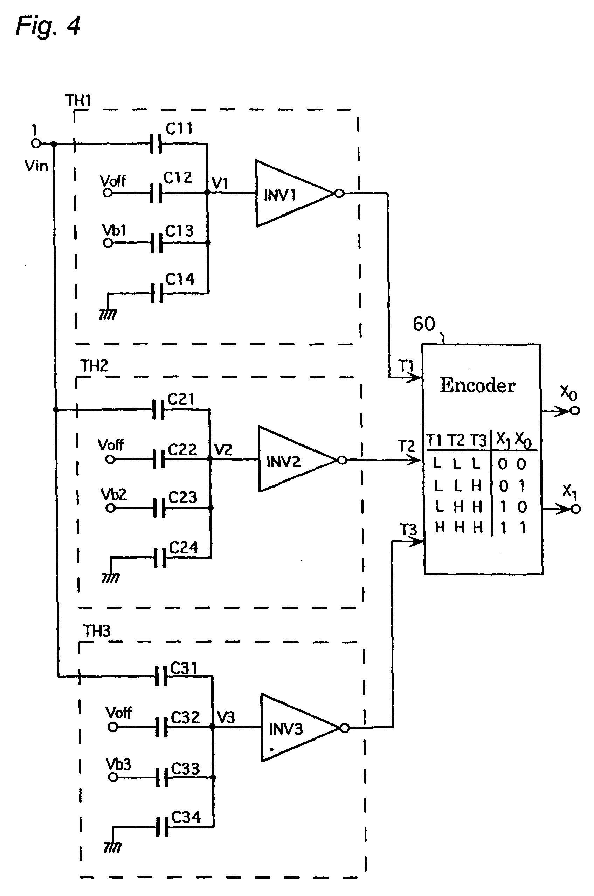

Although any structure can be employed in A/D converter 2, one with low electric power consumption is described with reference to FIG. 4. For simplification, output bit number M is 2 in FIG. 4.

In FIG. 4, TH1 to TH3 are threshold circuits which have identical structures. As shown, they include inverting amplifiers INV1 to INV3 which are configured by CMOS inverters, for example, and four input capacitances are connected to each amplifier INV1 to INV3. The outputs of INV1 to INV3 are input to encoder 60.

Number 1 is an input terminal for receiving signals, with input voltage Vin. This terminal 1 is connected to the first input capacitances C11, C21 and C31 of TH1, TH2 and TH3, respectively. Offset voltage Voff is input to the second input capacitances C12, C22 and C32, and bias voltage Vb is input to the third input capacitances C13, C23 and C33. The fourth input capacitances C14, C24 and C34 are connected to the grounded potential.

In this structure, the output voltage of the capacitive coupling at the input of TH1, that is, the voltage input to INV1, is V1, and formula (20) is true from the law of conservation of energy:$\text{C11(Vin-V1)+C12(Voff-V1)+C13(Vb1-V1)+C14(0-V1)=0}$ Consequently, V1 is calculated by formula (21):$\text{V} \text{1=} \frac{\text{C} \text{11} \text{Vin} \text{+} \text{C} \text{12} \text{Voff} \text{+} \text{C} \text{13} \text{Vb} \text{1}}{\text{C} \text{11+} \text{C} \text{12+} \text{C} \text{13+} \text{C} \text{14}}$ When V1 is equal to or greater than threshold voltage Vth of INV1 (usually, it is Vdd/2), the output of INV1 is low-level, which is expressed in formula (22):$\frac{\text{C} \text{11} \text{Vin} \text{+} \text{C} \text{12} \text{Voff} \text{+} \text{C} \text{13} \text{Vb} \text{1}}{\text{C} \text{11+} \text{C} \text{12+} \text{C} \text{13+} \text{C} \text{14}} \text{≥} \text{Vth}$ Therefore, when input voltage Vin satisfies formula (23), the output of INV1 is low-level:$\text{Vin} \text{≥} \frac{\text{C} \text{11+} \text{C} \text{12+} \text{C} \text{13+} \text{C} \text{14}}{\text{C} \text{11}} \text{Vth} \text{-} \frac{\text{C} \text{12} \text{Voff} \text{+} \text{C} \text{13} \text{Vb} \text{1}}{\text{C} \text{11}}$ The threshold voltage of TH1 is set by controlling C13. The values of C12 and Voff are designed for their product to cancel the offset of INV1.

The threshold voltages of TH2 and TH3 can be set similarly.

With the threshold voltages of TH1, TH2 and TH3 being -v, 0 and v, respectively, when the input voltage is lower than -v, all outputs of TH1, TH2 and TH3 stay high-level; when it is between -v to 0, the output of TH1 is low and those of TH2 and TH3 are high; when it is between 0 to v, the outputs of TH1 and TH2 are low and that of TH3 is high; and when it is higher than v, all the outputs of TH1 to TH3 are low. A 2-bit digital output can be output corresponding to each stage by inputting the outputs of TH1 to TH3 to encoder 60.

This structure makes possible an analog-to-digital converter with very low electric power consumption.

The three threshold circuits in FIG. 4 convert analog data into 2-bit digital data; to convert digital data with more bits, more threshold circuits can be configured in the converter.

As in the explanation above, in a first aspect of the present invention a matched filter with small circuit and low electric power consumption is provided. Its analog-to-digital converter including capacitive coupling and an inverter circuit further decreases electric power consumption.

FIG. 5 shows the overall structure of a filter circuit according to a second aspect of the present invention. To simplify the description, the parts are designated exactly as in FIG. 15. In FIG. 5, Hs is an auxiliary sampling and holding circuit connected to input terminal Din, MUXs shows a multiplexer circuit receiving the outputs from stages A₁ to A₁₆ of shift register SR to select and output one of them according to controlling signal CTL, Ms is an auxiliary multiplication circuit for multiplying the output of Hs and the coefficient output from MUXs. ADD shows an adder for receiving outputs from M₁ to M₁₆ and Ms, in which two addition circuits are set, as described later. Hout1 and Hout2 are holding circuits with identical configurations parallelly connected to the output of ADD: their outputs are connected to Dout as well as to one input of multiplexer MUX. All other parts are the same as those in FIG. 15.

The present filter circuit differs from the conventional one in FIG. 15 in that it has a sampling and holding circuit (Hs) and a multiplication circuit (Ms), two addition circuits in an adder (ADD), and double holding circuits (Hout1 and Hout 2).

In this filter circuit, H1 to H16, Hs, Hout1 and Hout2, M₁ to M₁₆ and Ms, and the two addition circuits in ADD can all be refreshed.

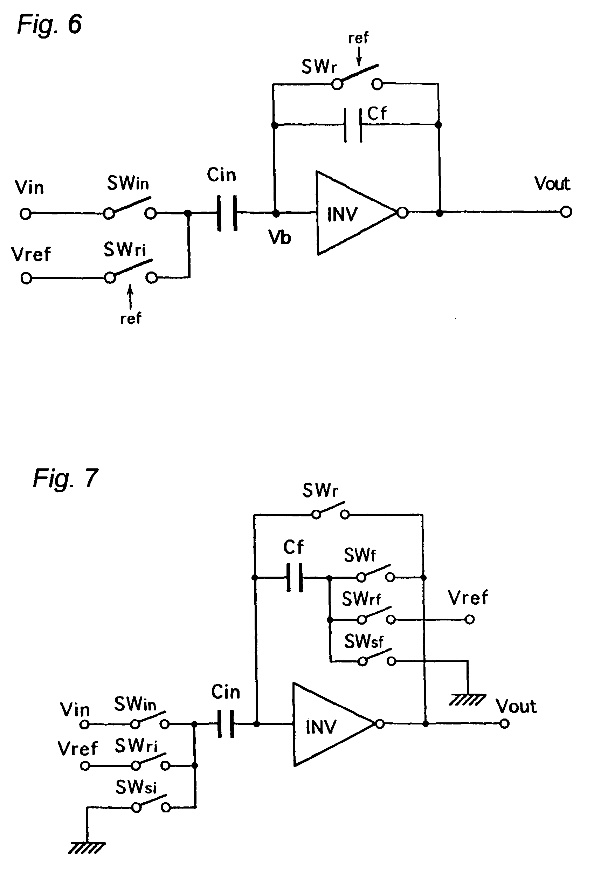

Hs and H₁ to H₁₆ have the same structure: an example is shown in FIG. 6. FIG. 6 consists of the same parts as those in FIG. 18 and their description is omitted. In FIG. 6, switch SWri is set to input the reference voltage Vref (=Vb) to input capacitor Cin, and switch SWr is set for short-circuiting feedback capacitor Cf. SWri and SWr have their conductivity governed by control signal ref; for example, they are conductive when signal ref is high-level.

Such sampling and holding circuit performs the same action as that in FIG. 18 is performed in the normal mode where ref is low-level and SWri and SWr are open.

During refreshing, ref is high-level and both SWri and SWr are closed so that the reference voltage Vref is given to the input of Cin and the feedback capacitor Cf is short-circuited. This cancels the residual charge stored in Cin and Cf, simultaneously and the reference voltage Vb (=Vref) is output from inverting amplifier INV.

FIG. 7 shows another configuration where Hs and H₁ to H₁₆ are able to be refreshed. The sampling and holding circuit in FIG. 3 is not only refreshable but also capable of sleep-mode operation, in which power consumption is very low.

As in FIG. 7, switch SWsi in this sampling and holding circuit is set at the input of Cin to control the connection between Cin and the ground in addition to SWin and SWri. At the output terminal of INV, switches SWf, SWrf and SWsf are provided to control the connection between the output of INV and the output terminal of Cf, that between the output terminal of Cf and Vref, and that between the output terminal of Cf and the ground, respectively. SWr is set between the output and input terminals of INV, as in FIG. 6, and it is opened and closed in conjunction with SWri and SWrf. SWri and SWsi, and SWrf and SWsf are closed selectively.

This sampling and holding circuit works like that in FIG. 18 in the normal mode where SWin and SWf are conductive, and SWri, SWsi, SWr, SWrf and SWsf are nonconductive.

When SWin, SWf, SWsi and SWsf are opened and SWri and SWrf are closed, the residual charges in Cin and Cf are cancelled and refreshed by transmitting Vref through the input of Cin and the output of Cf to short-circuit the input and output of INV. Then, the output of INV is Vb (=Vref).

Moreover, when SWin, Swf, SWri, SWr and SWrf are opened and SWsi and SWsf are closed, this circuit is in the sleep-mode. In this case, INV works under saturation without its Cf connection and with its input connected to the grounded potential. Power consumption in each CMOS inverter circuit is low enough to be ignored. SWsi can be connected to supply voltage Vdd instead of the ground to attain sleep-mode with low power consumption.

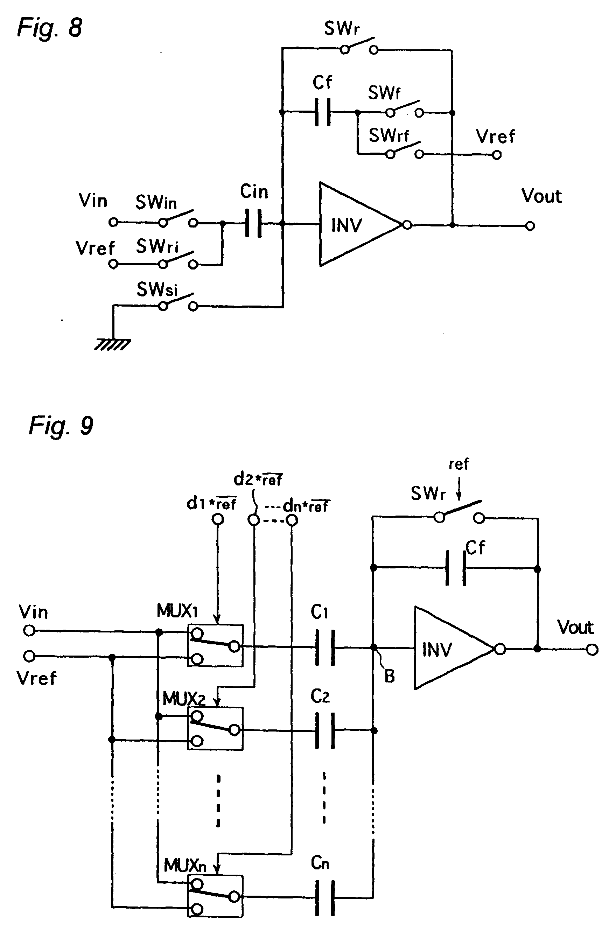

FIG. 8 shows one further example of Hs and H₁ to H₁₆. This embodiment derives from and simplifies FIG. 7 by moving SWsi for the sleep-mode directly to the input of INV from its previous location between the input of Cin and the ground, as well as eliminating SWsf for sleep-mode set at the output of Cf.

This sampling and holding circuit functions like that in FIG. 7 for normal work and refreshment. In sleep-mode, SWsi is conductive, and the input of INV is the grounded potential; consequently, INV is saturated and its power consumption is low enough to be ignored. This circuit simplifies that in FIG. 7 by connecting SWsi to the supply voltage.
According to the present invention, sampling and holding circuits H₁ to H₁₆ and Hs have refreshing means. Therefore, it is feasible to refresh H₁ to H₁₆ one after another in a predetermined cycle, and the function of refreshing these sampling and holding circuits can be replaced by Hs. Hs can be refreshed while no circuit among H₁ to H₁₆ is being refreshed.

Holding circuits Hout1 and Hout2 in FIG. 5 have structures similar to each sampling and holding circuit above: they are able to be refreshed by each control signal. These can also be refreshed alternately.

FIG. 9 shows a configuration of multiplication circuits M₁ to M₁₆ and Ms. FIG. 9 consists of the same parts as those in FIG. 19, and their detailed description is omitted. As shown, switch SWr is set for short-circuiting feedback capacitor Cf, and control signal ref is supplied to SWr as above. Control signals supplied to capacitor-switching multiplexers MUX₁ to MUXₙ are from (reversed ref) d₁* to dₙ*. "*" shows an AND operation. When ref is low level (normal work), SWr is opened, and MUX₁ to MUXₙ are controlled by its opening and closing according to d₁ to dₙ. In this case, the multiplications of n-bit digital coefficients and input analog voltages are performed like those of the multiplication circuit in FIG. 19.

When ref is high-level, SWr is closed and MUX₁ to MUXₙ are switched to select the reference potential Vref. Cf is short-circuited to cancel its residual charge, and, simultaneously, the residual charges of C₁ to Cₙ are also canceled, and so $\text{Vref=Vdd/2=Vb}$ is output from output terminal Vout.

Although FIG. 9 shows a configuration with refreshing means similar to that in FIG. 6, setting a switch to input the grounded potential or supply voltage creates an embodiment with a sleep-mode as in FIGS. 7 and 8.

As described, M₁ to M₁₆ have the refreshment-capable configurations. They can be refreshed one after another by replacing one of M₁ to M₁₆ with Ms, which also can be refreshed after M₁ to M₁₆ have been refreshed once through.

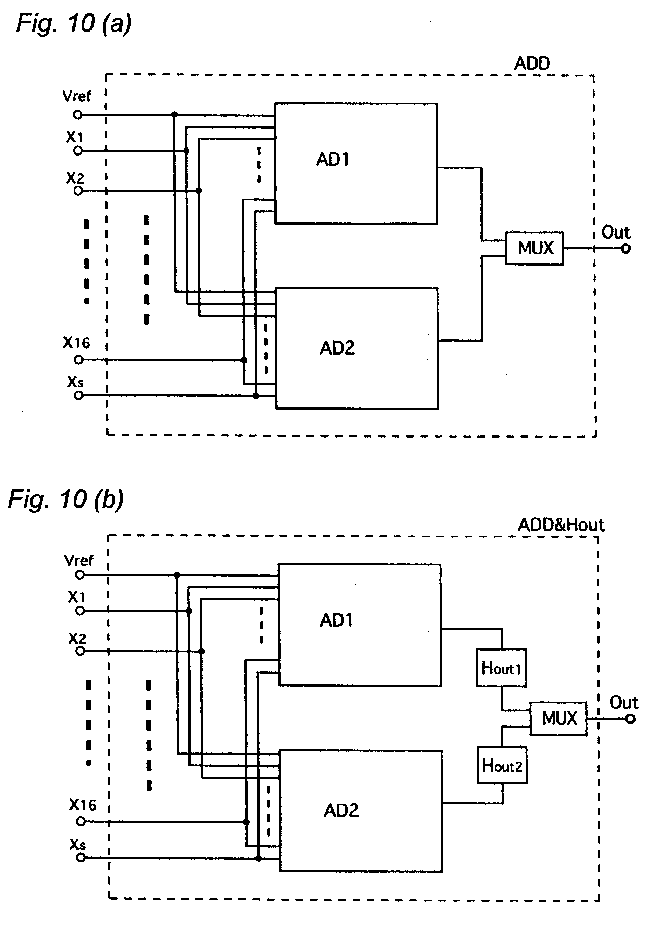

FIG. 10 (a) shows an embodiment of adder ADD. In FIG. 10 (a), X₁ to X₁₆ are input terminals for receiving the outputs of M₁ to M₁₆, Xs is an input terminal for receiving the output of Ms, AD1 and AD2 are addition circuits with the same configurations, MUX is a multiplexer for selectively producing the output of AD1 or AD2 at output terminal Out. In this structure, input signals from X₁ to X₁₆ and Xs are selectively input to the first addition circuit AD1 or the second addition circuit AD2, and their outputs are generated at Out through controlling MUX.

By alternately using AD1 and AD2, the one receiving no input signal can be refreshed.

FIG. 10 (b) shows an embodiment in which ADD, Hout1 and Hout2 are put together: Hout1 and Hout2 are directly connected to AD1 and AD2, respectively, so as to transmit each output of Hout1 and Hout2 to MUX. Alternately using the pairs of AD1 and Hout1 and AD2 and Hout2 means the addition circuit and holding circuit of the pair not in use can be refreshed.

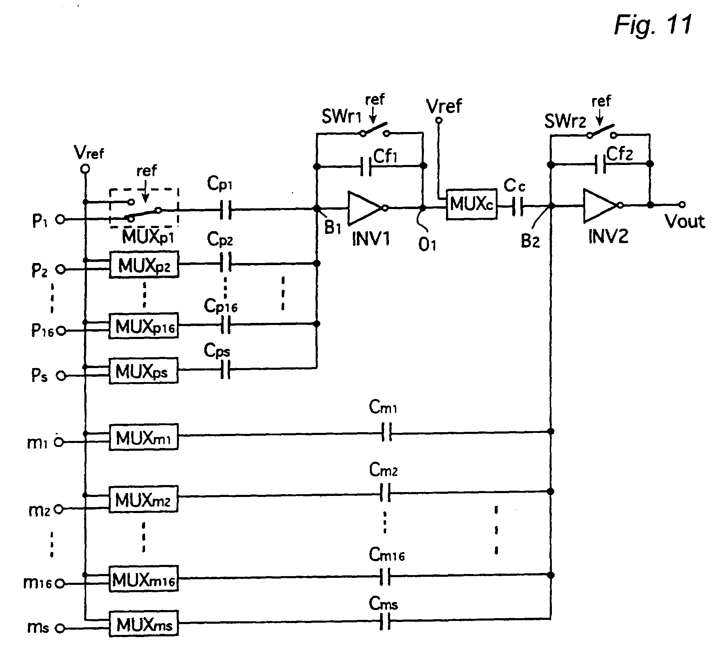

FIG. 11 shows the similarly-structured AD1 and AD2, which have the same configuration as that in FIG. 20 with refreshing means added. FIG. 11 consists of the same parts as those in FIG. 20, and their description is omitted. MUXₚ₁ to MUXₚ₁₆ are multiplexers supplied at the inputs of Cₚ₁ to Cₚ₁₆, which alternatively select input voltage Vₚ₁ to Vₚ₁₆ from p₁ to p₁₆, respectively, and reference potential Vref, according to control signal ref. MUXₘ₁ to MUXₘ₁₆ are multiplexers supplied at the inputs of input capacitors Cₘ₁ to Cₘ₁₆, which alternatively select, according to control signal ref, input voltage Vₘ₁ to Vₘ₁₆ from m₁ to m_{16,} respectively, and reference potential Vref.

Input terminals pₛ and mₛ are provided corresponding to multiplication circuit Ms, and these are used to input the output signal from Ms as it replaces the function of whichever one of multiplication circuits M₁ to M₁₆ being refreshed. MUXₚₛ and MUXₘₛ are multiplexers set corresponding to input terminals pₛ and mₛ, and Cₚₛ and Cₘₛ are input capacitors connected to multiplexers MUXₚₛ and MUXₘₛ. MUXₚₛ and MUXₘₛ alternatively select the reference potential and input voltage from pₛ and mₛ corresponding to ref, respectively, similar to MUXₚ₁ to MUXₚ₁₆ and MUXₘ₁ to MUXₘ₁₆.

Switches SWr1 and SWr2 are connected in parallel to feedback capacitors Cf₁ and Cf₂ of the first and second inverting amplifiers INV1 and INV2, respectively. SWr1 and SWr2 are conductive by ref.

Multiplexer MUXc is connected between O₁ of the output of INV1 and capacitive coupling Cc, which selectively inputs Vref or the output of INV1 to Cc. MUXc is configured to select Vref and the output of INV1 according to ref, like MUXₚ₁ to MUXₘₛ.

Addition circuits AD1 and AD2 with this configuration works in the same manner as the addition circuit in FIG. 20 to obtain the output voltage by subtracting the sum of input voltage Vₘ₁ to Vₘₛ from input terminals m₁ to mₛ from the sum of Vₚ₁ to Vₚₛ input from p₁ to p_{s.} The condition is that ref is low-level, MUXₚ₁ to MUXₚₛ and MUXₘ₁ to MUXₘₛ are controlled to select corresponding input terminals p₁ to pₛ and m₁ to mₛ, MUXc is controlled to select INV1 output, and SWᵣ₁ and SWᵣ₂ are opened, which is the normal mode.

When Vref is high level, AD1 and AD2 are refreshed in the same way in the sampling and holding circuits and the multiplication circuits above by managing all multiplexers MUXₚ₁ to MUXₚₛ, MUXₘ₁ to MUXₘₛ and MUXc to select Vref, so that SWᵣ₁ and SWᵣ₂ are short-circuited.

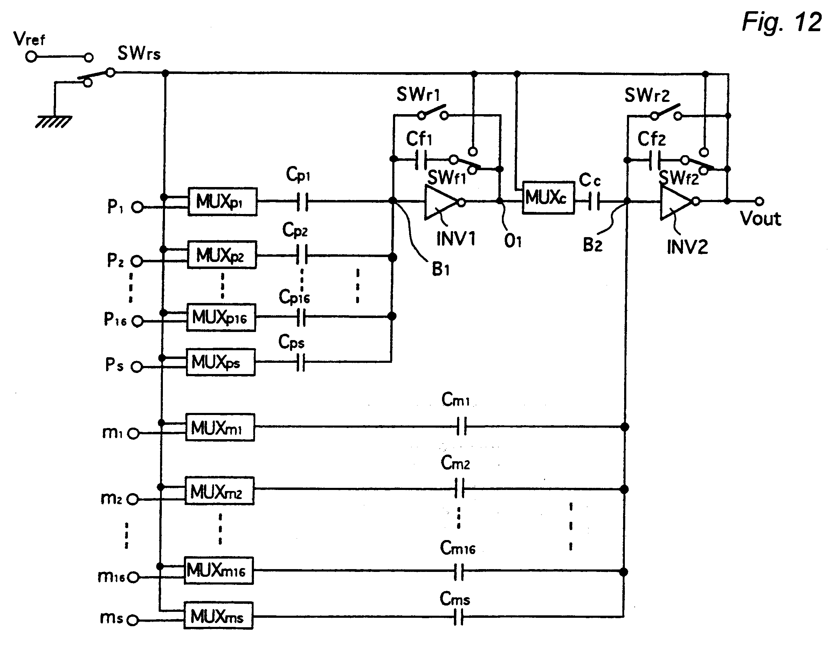

FIG. 12 shows an embodiment of the addition circuit with refreshing means: it has a circuit for sleep-mode structured like that of the sampling and holding circuit in FIG. 7. As shown, this circuit has switch SWrs for selectively supplying Vref or the grounded voltage to MUXₚ₁ to MUXₘₛ and MUXc, switch SWf1 for selectively connecting the output of feedback capacitor Cf₁ to the output of INV1, and switch SWrs for selectively connecting the output of feedback capacitor Cf₂ to the output of INV2, in addition to the components of the circuit in FIG. 11.

This addition circuit works in the same manner as that in FIG. 20 in the normal mode where SWf1 and SWf2 are connected to INV1 and INV2, respectively, SWᵣ₁ and SWᵣ₂ are opened, MUXₚ₁ to MUXₚₛ and MUXₘ₁ to MUXₘₛ are directed to select corresponding p₁ to pₛ and m₁ to mₛ, and MUXc is managed to select the output of INV1.

When SWrs is connected to select Vref, SWr1 and SWr2 are conductive, SWf1 and SWf2 are connected to SWrs, and MUXp1 to MUXms and MUXc are controlled to select SWrs, Vref is supplied to the input of Cₚ₁ to Cₘₛ, the input of Cc, and the outputs of Cf₁ and Cf₂, and both the outputs and inputs of INV1 and INV2 are short-circuited thereby effecting a canceling of the residual charge and refreshment.

When SWrs is grounded, SWr1 and SWr2 are opened, SWf1 and SWf2 are connected to SWrs, and MUXₚ₁ to MUXₘₛ and MUXc are controlled to select SWrs, the inputs of Cₚ₁ to Cₘₛ and Cc, and the outputs of Cf₁ and Cf₂ receive the grounded potential, resulting in the saturation of inverters INV1 and INV2, which are supplied the grounded voltage. This is the sleep-mode whose power consumption is low enough to be ignored. SWrs, moreover, can be connected to supply voltage instead of the grounded potential.

As shown in FIG. 12, the structure is simplified by connecting this circuit to Vref and the grounded potential through the common switch SWrs. It can be refreshed and put in the sleep-mode with the same connection in FIG. 8. Also, AD1 and AD2 are refreshable.

As in the above description, sampling and holding circuits H1 to H16 and Hs, holding circuits Hout1 and Hout2, multiplication circuits M1 to M16 and Ms, addition circuits AD1 and AD2 in adder ADD can all be refreshed in the present filter circuit. That is, it differs from the conventional one in FIG. 15, in that sampling and holding circuit Hs and multiplication circuit Ms are provided, adder ADD includes double addition circuits AD1 and AD2, and holding circuits are set double as Hout1 and Hout2, which enables refreshment of each sampling and holding circuit, each multiplication circuit, the addition circuit and holding circuit. There is no sacrifice of operating speed because operations continue using Hs and Ms while the sampling and holding circuit and multiplication circuit being refreshed. The necessary hardware increases minimally and power consumption increases even less, because only one sampling and holding circuit Hs and one multiplication circuit Ms are necessary for a plurality (here, 16) of sampling and holding circuits H₁ to H₁₆ and of multiplication circuits M₁ to M₁₆, respectively.

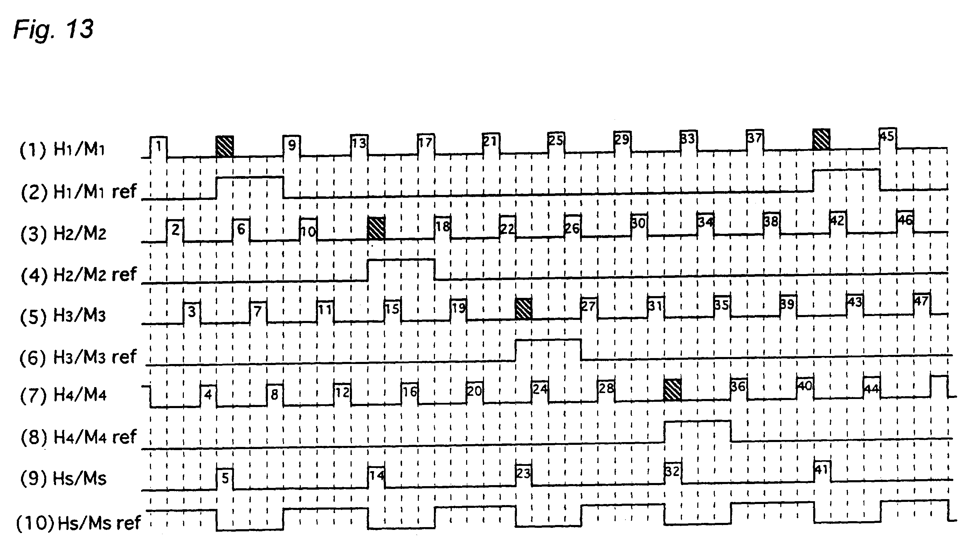

FIG. 13 shows the refreshment timing chart for this filter circuit. To simplify the description, a four-stages filter circuit is adopted here. That is, this filter circuit includes four sampling and holding circuits of H₁ to H₄ and another, Ms, for refreshing, and four multiplication circuits M₁ to M₄, with another, Ms, for refreshing.

In FIG. 13, (1), (3), (5) and (7) show the action timings of H₁ to H₄, and (9) shows that of Ms: the high states show the sampling periods and low states show the holding periods. A sampling period with diagonal lines shows the state when Hs is replacing the functions of one circuit among H₁ to H₄ being refreshed. That is, sampling clocks are provided to Hs during this period to Hs so that input signals are sampled.

The remaining (2), (4), (6), (8) and (10) show the refreshing timings of H₁ to H₄ and Hs: the high state show the refreshment-capable periods, and the low state show the refreshment-incapable periods. That is, data is not stored in the sampling and holding circuit during high-state; therefore, the sampling and holding circuit can be refreshed during this period.

In FIG. 13, sampling and holding circuit H₁ is driven at sampling timing 1 to sample and hold input signals. Likewise, H₂, H₃, and H₄ are driven at the sampling timings 2, 3, and 4 to sample and hold the corresponding input signals. At sampling timing 5, sampling and holding circuit Hs is driven to sample and hold its input signals: this is originally the timing H₁ is driven at.

As H₁ does not sample input data after timings 5 has passed and before timing 9 starts, it can be refreshed during this period. A circuit control (not shown) provides the control signal for refreshing - in FIG. 6, for example, ref closes switches SWri and SWr - and refreshment is carried out.

At sampling timing 5, control signal CTL is provided to multiplexer MUXs (FIG. 5) to select the outputs of stage A₁ which stores the multiplication coefficients corresponding to sampling and holding circuit H₁ in cyclic shift register SR, and multiplication circuit Ms receives the output of sampling and holding circuit Hs and coefficient aⱼ stored in A₁. Then, the output voltage of H₁ and the multiplier stored in A₁ are multiplied in Ms - originally the multiplication is performed in M₁ - and adder ADD receives the results at this timing.

At the timing when H₁ is refreshed (any timing from 5 to 8), its corresponding multiplication circuit M₁ is simultaneously refreshed through receiving high-level control signal ref from the control circuit (not shown). Here, the output from M₁ is Vref, which is the 0-input to ADD, and which gives no influence to the output of ADD.

At sampling timings from 6 to 8, sampling and holding and multiplication are sequentially executed using sampling and holding circuits H₂ to H₄ and Hs, multiplication circuits M₂ to M₄ and Ms. At sampling timing 9, normal processing is performed using H₁ completed its refreshment, and M₁.

At sampling timing 14, at which H₂ is originally driven, Hs is driven to refresh H₂ and M_{2,} as above. H₁ to H₄ and M₁ to M₄ are sequentially refreshed in this way.

As shown in (10) in FIG. 13, Hs and Ms are refreshment-capable at timings 9 to 13 and 18 to 22 when H₁ to H₄ and M₁ to M₄ are used.

When AD1 and AD2 (or the addition circuit and holding circuit in FIG. 8 (b)) are alternately used synchronously to once-through refreshment of H₁ to H₄ and M₁ to M₄, the one not in use can be refreshed.

Although H₁ to H₄ are refreshed by the sampling cycle of (2×4 (=filter stage number)+1), other cycles are feasible. A larger cycle means fewer refreshments and thus lower power consumption. However, the cycle is limited owing to the residual charge caused by the leakage in the analog operation circuit.

As mentioned, because it includes refreshing means, according to a second aspect the present invention can prevent from lowering of output accuracy caused by the residual charge in analog operation circuit. Also, it is possible to refresh sampling and holding circuits and multiplication circuits without decreasing processing speed and with minimal hardware increase because an auxiliary sampling and holding circuit and an auxiliary multiplication circuit are commonly provided to a plurality of sampling and holding circuits and multiplication circuits.

## Claims

1. A matched filter comprising:
i) an analog-to-digital converter for sampling and converting an input signal into predetermined digital data;
ii) a shift-register having a predetermined number of stages for receiving the output of said analog-to-digital converter;
iii) an EXCLUSIVE-OR circuit corresponding to each stage of said shift-register, for performing EXCLUSIVE-OR operations between said predetermined bits of digital data output from the stage corresponding to said shift-register and its corresponding bit of spread code; and
iv) an adder for adding the output of each said EXCLUSIVE-OR circuit.

2. The matched filter according to claim 1, wherein said analog adder is configured by analog addition circuits with the number corresponding to the bit numbers of said digital data for receiving bits with weights corresponding to the output of those from each said EXCLUSIVE-OR circuit, and analog adders for giving corresponding weights to add to the outputs from each said analog adder.

3. The matched filter according to claim 1 or 2, wherein said analog-to-digital converter is comprised of a predetermined number of threshold circuits comprising a capacitive coupling and an inverting amplifier, and an encoder for receiving the outputs of said threshold circuits.

4. A filter circuit comprising:
i) a plurality of sampling and holding circuits for successively performing sampling and holding on input analog signals;
ii) a cyclic shift register for storing coefficient data in each stage;
iii) a plurality of analog multiplication circuits for multiplying the output signals from said plurality of sampling and holding circuits and coefficient data from said cyclic shift register; and
iv) an analog addition circuit for calculating output sums of said multiplication circuits;
wherein said plurality of sampling and holding circuits, multiplication circuits and addition circuits comprise refreshing means for canceling offset voltage caused by the residual charge.

5. The filter circuit according to claim 4, wherein an auxiliary sampling and holding circuit, an auxiliary multiplication circuit and an auxiliary addition circuit for replacing said sampling and holding circuits, said multiplication circuits and said addition circuits, respectively, are provided to be used for refreshing.

6. The filter circuit according to claim 5, wherein said auxiliary sampling and holding circuit and said auxiliary multiplication circuit are commonly provided to said plurality of sampling and holding circuits and said plurality of multiplication circuits, respectively.

7. The filter circuit according to claim 5, wherein said auxiliary sampling and holding circuit, auxiliary multiplication circuit and auxiliary addition circuit comprise refreshing means for canceling offset voltage caused by the residual charge.

8. The filter circuit according to one of claims 4 to 7, wherein:
i) each said sampling and holding circuit, said multiplication circuit, said addition circuit, said auxiliary sampling and holding circuit, said auxiliary multiplication circuit and said auxiliary addition circuit comprise an inverting amplifier consisting of an odd number of stages of serially connected CMOS inverters, an input capacitor connected to the input of said inverting amplifier, and a feedback capacitor connected between the input and output of said inverting amplifier; and
ii) said refreshing means comprises a switching means for short-circuiting said feedback capacitor and a means for supplying the reference voltage to the input of said input capacitor.

9. The filter circuit according to one of claims 4 to 7, wherein:
i) each said sampling and holding circuit, said multiplication circuit, said addition circuit, said auxiliary sampling and holding circuit, said auxiliary multiplication circuit and said auxiliary addition circuit comprise an inverting amplifier consisting of an odd number of stages of serially connected CMOS inverters, an input capacitor connected to the input of said inverting amplifier, and a feedback capacitor connected between the input and output of said inverting amplifier; and
ii) said refreshing means comprises a switching means for short-circuiting said feedback capacitor and a means for supplying the reference voltage to the input of said input capacitor and the output of said feedback capacitor.
